# EUROPÄISCHE PATENTSCHRIFT

(11) **EP 2 114 116 B1**
(45) Veröffentlichungstag und Bekanntmachung des Hinweises auf die Patenterteilung: **05.06.2013**
(21) Anmeldenummer: 08008204.3
(22) Anmeldetag: 29.04.2008
(51) Int. Cl.: H05K 7/20

(54) **Hybridkühlung**
Hybrid cooling
Refroidissement hybride

(43) Veröffentlichungstag der Anmeldung: 04.11.2009
(73) Patentinhaber: Agie Charmilles SA, 6616 Losone (CH); CHARMILLES TECHNOLOGIES S.A., 1217 Meyrin 1 (CH)
(72) Erfinder: Bühler, Ernst, 6616 Losone (CH); Knaak, Reto, 6612 Ascona (CH); D'Amario, Rino, 6806 Sigirino (CH); Lombardo, Rosario, 28822 Cannobio (IT)
(74) Vertreter: Samson & Partner

(56) Entgegenhaltungen:
- EP-A- 0 641 155
- DE-U1- 20 317 869
- GB-A- 1 018 623
- US-A1- 2004 042 184
- US-A1- 2007 002 538

## Beschreibung

### GEBIET DER ERFINDUNG

Die Erfindung betrifft eine Hybrid-Kühlung für eine Leiterplatteneinheit für eine Werkzeugmaschine und ein Verfahren zum Kühlen einer Leiterplatteneinheit für eine Werkzeugmaschine.

### HINTERGRUND DER ERFINDUNG

Immer häufiger werden beispielsweise leistungselektronische Lösungen für Aufgaben verlangt, welche früher, wenn überhaupt, mit mechanischen oder elektromechanischen Mitteln gelöst wurden. Die ständig steigenden Arbeits- und Materialkosten, sowie Volumen und Gewicht der elektronischen Baugruppen sind dabei zum Haupthindernis für innovative Lösungen geworden. Die kostenintensivsten Anteile sind meistens die manuelle Bestückung von Baugruppen, die eine starke Wärmeleistung produzieren, wie z.B. Leistungshalbleiter, sowie deren Montage auf Kühleinrichtungen zur Wärmeabfuhr der entstehenden Wärmeleistung. Die Zuverlässigkeit einer Baugruppe ist gegenwärtig insbesondere durch die Qualität dieser manuellen Arbeitsabläufe bestimmt. Die Qualitätssicherung wird dadurch wesentlich verteuert.

Die Herstellung, Prüfung, der Betrieb und die Wartung derartiger elektronischer Baugruppen muss im internationalen Umfeld erfolgreich bestehen können. Dazu sind geringe Material- und Herstellkosten erforderlich, aber es müssen auch Reparaturen, Modifikationen und zuletzt eine umweltgerechte Entsorgung garantiert werden können. Die Fertigungsprozesse müssen bedeutend zuverlässiger werden, um die Herstellkosten zu senken. Weiter ist es vorteilhaft, wenn gleiche oder ähnliche Module für Hochpreis- und Billigprodukte eingesetzt werden können.

Eine völlig neue Herausforderung hat sich beim Bau von Werkzeugmaschinen ergeben, wo man die Elektronikschränke durch Module ersetzen möchte, welche dann direkt in die Maschine einzubauen wären. Da Werkzeugmaschinen auf Abwärme mit Dehnungen und Verwindungen reagieren, muss der Wärmeabfuhr besondere Aufmerksamkeit geschenkt werden.

Im Falle von Funkenerosionsmaschinen ist die Lage besonders schwierig, da auch Impulsgeneratoren mit einer Abwärme im Kilowattbereich einzubauen sind.

### STAND DER TECHNIK

Für die Antriebstechnik und verwandte Gebiete werden seit langer Zeit Module angeboten. Es handelt sich meist um ein- bis dreiphasige Brückenschaltungen von Dioden-, IGBT- oder MOSFET- Bauelementen in Chipform, welche auf ein spezielles Kupfer-Keramiksubstrat aufgelötet und mit Bonddrähten kontaktiert sind. Es wäre denkbar, Spezialausführungen solcher Module mit einer Kühleinrichtung zu versehen und zusammen mit der Steuerelektronik in ein Gehäuse zu verpacken.

Nachteilig bei dieser Lösung ist, dass der Integrationsgrad der Module viel zu gering ist, um komplexere Schaltungen zu realisieren, und dass ein Teilausfall in einem Modul nicht repariert werden kann. Viele qualitätskritische, manuelle Fertigungsprozesse, wie das Aufbringen von Wärmeleitpaste oder heikle Schraubverbindungen bleiben bei dieser Lösung bestehen. Die Verlustwärme der Steuerelektronik kann auch erheblich sein - dieses Problem ist ebenfalls nicht gelöst.

Für Großserien in der Autoindustrie und in der Antriebstechnik werden immer häufiger komplexe leistungselektronische Module in SMD-Technologie (Surface Mount Device) eingesetzt, wobei die SMD-Komponenten einseitig auf eine Leiterplatte aufgebracht werden. Die Unterseite der Leiterplatte ist für die Wärmeabfuhr meistens mit einer metallischen Grundplatte verklebt. Eine solche Lösung ist in der EP 0 590 354 B1 offenbart und in Fig. 3 als Stand der Technik dargestellt. Das Modul wird über die Grundplatte an ein Kühlsystem angeschlossen. Meistens werden spezielle, dünne Isolationslagen mit erhöhter Wärmeleitfähigkeit verwendet, um die Leistungselemente besser zu kühlen.

Module dieser Art stellen einen Fortschritt dar, haben aber die Nachteile, dass sie einerseits für höhere Verlustleistungen noch ungenügend kühlen und anderseits fast nicht reparierbar sind, weil bei Reparaturprozessen die massive Grundplatte eine derart hohe Wärmesenke darstellt, dass man die Löttemperatur von bleifreien Loten kaum erreichen kann, ohne die ganze Schaltung zu schädigen. Um die wärmeleitende Isolationslage effektiv zu gestalten, wird diese in geringster Dicke gefertigt, was leider zu nachteilig hohen elektrischen Streukapazitäten führt und für höhere Spannungen und Frequenzen sehr ungünstig ist.

Eine Variante dieser Lösung sieht zwei Leiterplatten vor, welche mit einem Kern von etwa 1 mm bis 5mm Aluminium oder Kupfer verklebt sind, und auch mit isolierten Kontaktierungen zwischen den zwei Leiterplatten versehen werden können. Die aufgeführten Hauptnachteile bleiben bestehen, zusätzlich werden aber die Bauelemente gegen das Zentrum der Leiterplatte hin wegen der beschränkten lateralen Wärmeleitung der Kühlplatte erheblich schlechter gekühlt, da die Wärme nur über die Ränder der Leiterplatte abgeführt wird.

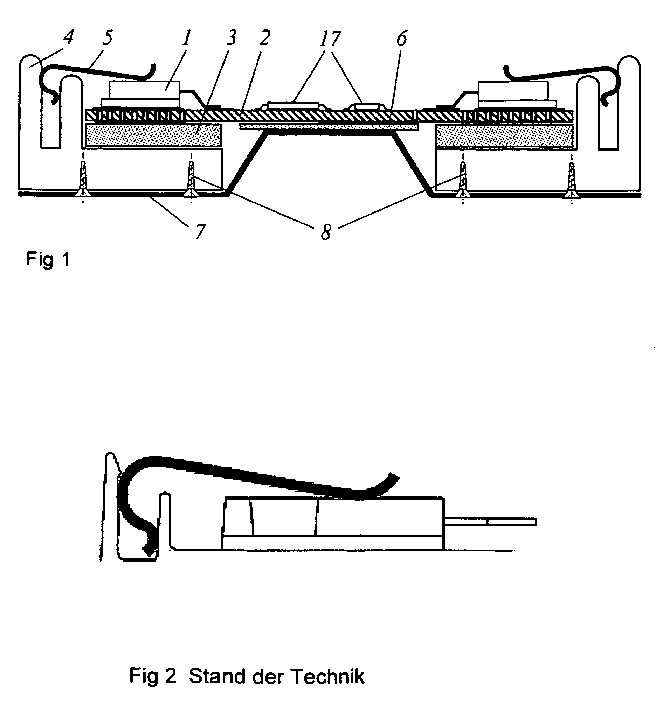

Die Fig. 2 zeigt einen typischen bekannten Aufbau der Firma AAVID THERMALLOY für eine bedrahtetes TO247-Leistungselement, welches mit einem metallischen Clip - ohne elektrische Isolation - auf ein Kühlkörperprofil gepresst wird. Durch die fehlende elektrische Isolation können ungünstige Potentialverteilungen entstehen.

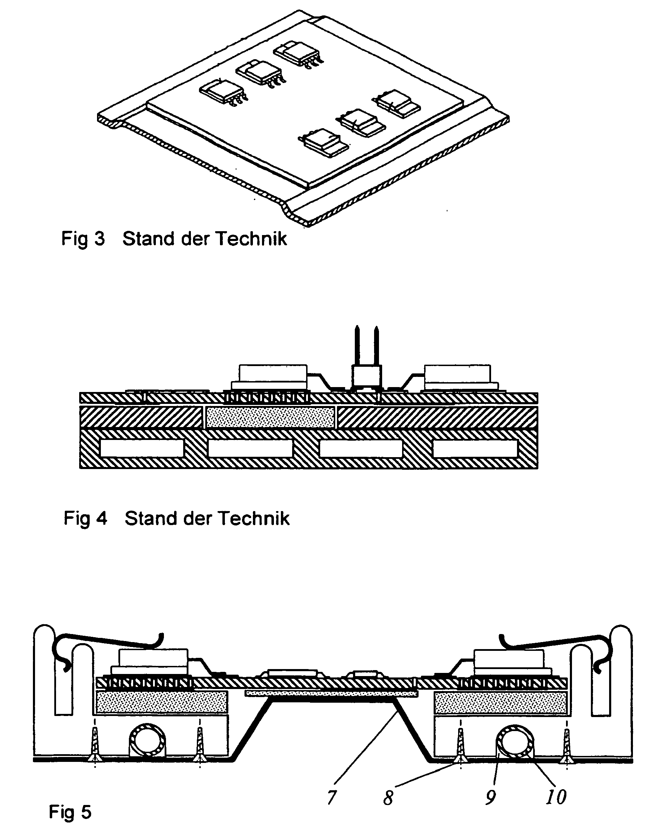

In der Patentanmeldung Nr. EP 06 02 2498 wird eine Leiterplatte mit direkt integriertem Flüssigkeitskühler offenbart, welche mit heute üblichen Fertigungsverfahren für Leiterplatten herstellbar ist. Der Inhalt dieser Patentanmeldung EP 06 02 2498 wird durch Verweis in die vorliegende Anmeldung einbezogen. In der Leiterplatte sind Keramikeinlagen zur besseren Wärmeleitung unter SMD-Elementen mit hoher Wärmebelastung eingebettet. Fig. 4 zeigt diesen Aufbau als Stand der Technik.

Diese Lösung erfüllt die gestellten Anforderungen für die moderne GroßSerienfertigung, verlangt aber teils Fertigungsschritte, welche für technologisch weniger entwickelte Werkplätze zu einem ernsthaften Hindernis werden können. Als weiterer Nachteil dieser Patentanmeldung muss die Tatsache gesehen werden, dass eine Luftkühlung von Vornherein ausgeschlossen ist. Dies kann sich nachteilig auf die Herstellungskosten von Niedrigpreisprodukten auswirken. Ein weiteres Problem tritt bei einer Überlastung mit unzulässiger Temperaturexkursion von Leistungselementen auf. Solche Störfälle können zu einer Delaminierung der einzelnen Schichten der Leiterplatte und zur Blasenbildung führen und damit den Totalausfall des gesamten Moduls hervorrufen.

Aus US 2007/0002538 A1 ist eine Hybridkühlung für einen tragbaren Computer bekannt. Bei dieser Hybridkühlung wird eine Leiterplatte mit flüssigem Kühlmittel gekühlt. Dem Kühlkörper mit Flüssigkühlung ist ein Wärmetauscher nachgeschaltet, in dem die Kühlflüssigkeit Wärme an Luft abgeben kann.

### AUFGABE DER ERFINDUNG

Gegenüber dem Stand der Technik liegt der Erfindung die Aufgabe zugrunde, eine Kühlung für eine Leiterplatteneinheit für eine Werkzeugmaschine und ein entsprechendes Kühlverfahren bereitzustellen, die eine ausreichende Wärmeabfuhr der Verlustwärme von oberflächenmontierbaren Bauelemente sicherstellen können. Bevorzugt soll dies mit einfachen Mitteln erreicht werden.

### KURZFASSUNG DER ERFINDUNG

Ein erster Aspekt der vorliegenden Erfindung betrifft Hybrid-Kühlung für eine Leiterplatteneinheit für eine Werkzeugmaschine, mit: wenigstens einem Kühlkörper der derart ausgebildet ist, dass er Wärme von oberflächenmontierbaren Leistungsbauelementen auf der Leiterplatteneinheit aufnehmen kann, wobei der Kühlkörper einen Bereich zur Flüssigkeitskühlung und einen Bereich zur Luftkühlung aufweist, so dass er Wärme sowohl an ein gasförmiges als auch ein flüssiges Kühlmedium abgeben kann. Der Wärmefluss zu den Bereichen des Kühlkörpers, die flüssig gekühlt werden, ist von dem Wärmefluss zu den Bereichen des Kühlkörpers, die gasförmig gekühlt werden, entkoppelt.

Ein zweiter Aspekt der vorliegenden Erfindung betrifft ein Verfahren zum Kühlen einer Leiterplatteneinheit für eine Werkzeugmaschine, bei welcher ein Kühlkörper (4), der Wärme von wenigstens einem oberflächenmontierbaren Leistungselement (1), das auf der Leiterplatteneinheit angeordnet ist, aufnimmt, sowohl durch ein flüssiges als auch ein gasförmiges Kühlmedium gekühlt wird. Der Wärmefluss zu den Bereichen des Kühlkörpers, die flüssig gekühlt werden, ist von dem Wärmefluss zu den Bereichen des Kühlkörpers, die gasförmig gekühlt werden, entkoppelt.

Weitere Aspekte und Merkmale der Erfindung ergeben sich aus den abhängigen Ansprüchen, der beigefügten Zeichnung und der nachfolgenden Beschreibung bevorzugter Ausführungsformen.

### KURZBESCHREIBUNG DER ZEICHNUNGEN

Nachfolgend werden unter Bezugnahme auf die beiliegenden Zeichnungen bevorzugte Ausführungsformen der Erfindung näher erläutert.

Es zeigen:
- Fig. 1: Ein Leistungsmoduls mit Luftkühlung.
- Fig. 2: Eine typische Clip Montage für bedrahtete Bauelemente nach dem Stand der Technik.
- Fig. 3: Ein bekanntes Verfahren zur Kühlung von SMD-Bauelementen nach dem Stand der Technik (EP 0 590 354 B1).
- Fig. 4: Ein bekanntes Verfahren zur Kühlung von SMD-Bauelementen nach dem Stand der Technik (Anmeldenummer EP 06 02 2498).
- Fig. 5: Eine erste Ausführungsform einer Flüssigkeits- und/oder Luftkühlung eines Leistungsmoduls.
- Fig. 6: Eine weitere Ausführungsform einer Hybridkühlung, die stapelbar ist.
- Fig. 7: Ein System-Paket aus stapelbaren Leistungsmodulen nach Fig.6.
- Fig. 8: Eine weitere stapelbare Ausführungsform einer Hybrid-Kühlung eines Leistungsmoduls, das eine Leistungsplatte und eine Steuerplatte aufweist.
- Fig. 9: Ein System-Paket aus stapelbaren Leistungsmodulen nach Fig.8.
- Fig. 10: Eine weitere Ausführungsform einer stapelbaren Hybrid-Kühlung eines Leistungsmoduls.
- Fig. 11: Ein System-Paket aus stapelbaren Leistungsmodulen nach Fig. 10.
- Fig. 12: Eine weitere stapelbare Ausführungsform mit Clips für die Flüssigkeitskühlung.
- Fig. 13: Ein System-Paket aus stapelbaren Leistungsmodulen nach Fig. 12.
- Fig. 14: Eine weitere stapelbare Ausführungsform mit Kühlrippen, welche das elastische Einpressen von dünnwandigen Kühlrohren ermöglichen.
- Fig. 15: Ein System-Paket aus stapelbaren Leistungsmodulen mit teilweise eingesetzten Kühlrohren nach Fig. 14.
- Fig. 16: Eine weitere stapelbare Ausführungsform mit einem verbesserten Wärmefluss.
- Fig. 17: Ein System-Paket aus Leistungsmodulen mit der Hybrid-Kühlung nach Fig. 16, welche durch elastische Kühlrohre zusammengehalten werden.
- Fig. 18: Eine weitere Ausführungsform mit einem verbesserten Wärmefluss und modifizierter Ausformung für die Stapelung.
- Fig. 19: Ein System-Paket aus Ausführungsformen nach Fig. 18, wobei das letzte Modul kopfüber eingesetzt wird.
- Fig.20: Eine weitere stapelbare Ausführungsform mit einer modifizierten Ausformung für die Stapelung.
- Fig. 21: Ein System-Paket aus Ausführungsformen nach Fig. 20, wobei das letzte Modul kopfüber eingesetzt wird.

### BESCHREIBUNG BEVORZUGTER AUSFÜHRUNGSFORMEN

In Fig. 1 stellte eine Leiterplatteneinheit (im Folgenden auch Leistungsmodul oder nur Modul genannt) mit einem Kühlkörper (4) dar, welche beispielsweise wenigstens teilweise aus handelsüblichen Komponenten hergestellt werden kann. Vor einer detaillierten Beschreibung der Ausführungsform von Fig. 1, folgen zunächst allgemeine Erläuterungen zu den Ausführungsformen der vorliegenden Erfindung und deren Vorteile.

Manche Ausführungsformen der Hybrid-Kühlung in Übereinstimmung mit der vorliegenden Erfindung sind zur Kühlung einer Leiterplatteneinheit für eine Werkzeugmaschine, insbesondere eine Funkenerosionsmaschine, geeignet.

Manche Ausführungsformen der Hybrid-Kühlung umfassen einen Kühlkörper, der eine geeignete Wärmeleitfähigkeit aufweist und bspw. aus einem gut wärmeleitenden Material, wie z.B. Metall, besteht. Der Kühlkörper ist weiterhin derart ausgebildet, dass er Wärme von einem oder mehreren oberflächenmontierbaren Leistungsbauelementen aufnehmen kann, wobei die Leistungsbauelemente auf einer Leiterplatteneinheit angeordnet sind. Der Kühlkörper ist ferner derart ausgebildet, dass er Wärme sowohl an ein gasförmiges als auch ein flüssiges Kühlmedium abgeben kann und weist dazu einen Bereich zur Flüssigkeitskühlung und einen Bereich zur Luftkühlung auf. Der Kühlkörper wird demnach durch zweierlei Kühlmedien gekühlt: ein flüssiges und ein gasförmiges. Dies führt dazu, dass bei manchen Ausführungsformen der Ausfall einer der beiden Kühlmechanismen nicht zum unmittelbaren Totalverlust der Kühlleistung führt. Der Kühlkörper ist bei manchen Ausführungsformen einstückig, bei anderen wiederum mehrteilig ausgebildet.

Der Bereich zur Flüssigkeitskühlung weist bei manchen Ausführungsformen wenigstens einen Kanal auf, in dem bei manchen Ausführungsformen beispielsweise Kühlrohre angeordnet sind. Die Kühlrohre sind bei manchen Ausführungsformen so dünnwandig, dass sie durch elastische Deformation an die Kanäle angepasst sind. Dadurch ist es möglich, die Kühlrohre einfach in die Kanäle einzupressen. Bei manchen Ausführungsformen ist der Kühlkörper zusätzlich derart ausgebildet, dass er wenigstens einen elastischen Clip so aufnehmen kann, dass die Kühlrohre in die Kanäle des Kühlkörpers eingepresst werden. Bei manchen Ausführungsformen wird das Dielektrikum bzw. Bearbeitungsflüssigkeit der Werkzeugmaschine, welches von der Werkzeugmaschine bei manchen Ausführungsformen bereits gekühlt wird, als flüssiges Kühlmedium verwendet.

Der Bereich zur Luftkühlung weist bei manchen Ausführungsformen ein Kühlkörperprofil auf, welches beispielsweise bei manchen Ausführungsformen so ausgestaltet ist, dass ein Kamineffekt bei dem gasförmigen Kühlmedium entsteht, welches das Kühlkörperprofil umgibt. Der Kamineffekt entsteht dadurch, dass das Kühlkörperprofil Wärme an das gasförmige Kühlmedium abgibt, wodurch dieses sich erwärmt und aufgrund der verringerten Dichte aufsteigt. Das Kühlkörperprofil ist demnach bei manchen Ausführungsformen so ausgebildet, dass es den Kamineffekt begünstig und das aufsteigende erwärmte gasförmige Kühlmedium beim Aufsteigen nicht behindert. Zusätzlich kann das Kühlkörperprofil weitere Ausgestaltungen aufweisen, wie bspw. eine trichterartige Struktur, die den Kamineffekt weiter begünstigt. Bei manchen Ausführungsformen umfasst das Kühlkörperprofil auch Kühlrippen. Dadurch wird bspw. der Wärmeübergangs-Widerstand zwischen dem Kühlkörper bzw. dem Kühlkörperprofil und dem das Kühlkörperprofil umgebenden gasförmigen Kühlmedium verringert. Ferner weisen manche Ausführungsformen ein Gebläse zur Kühlluftzufuhr und/oder Kühlluftabfuhr auf. Das Gebläse umfasst dabei bspw. einen Ventilator, dessen Drehzahl bspw. in Abhängigkeit einer gemessenen Temperatur oder dergleichen gesteuert werden kann.

Dadurch ist es möglich aktiv die Kühlleistung der Hybrid-Kühlung zu steuern. Gleiches gilt für die Flüssigkeitskühlung, deren Kühlleistung bspw. durch das Volumen und die Fließgeschwindigkeit des flüssigen Kühlmediums gesteuert werden kann. Ferner wird bei manchen Ausführungsformen bspw. die Form des Kühlkörperprofils, bspw. die Größe und Anzahl der Kühlrippen, und die Anzahl der Kühlrohre an die gewünschte Kühlleistung angepasst. Bei manchen Ausführungsbeispielen werden beispielsweise die Kühlrohre in Zwischenräumen zwischen den Kühlrippen angeordnet und die Anzahl der Kühlrippen und/oder der Kühlrohre bestimmt die zu erwartende Kühlleistung.

Bei manchen Ausführungsformen ist der Wärmefluss (von einer Wärmequelle, wie bspw. ein Leistungsbauelement) zu den Bereichen des Kühlkörpers, die flüssig gekühlt werden, von dem Wärmefluss zu den Bereichen des Kühlkörpers, die gasförmig gekühlt werden, im Wesentlichen entkoppelt. Daraus folgt, dass bspw. der Kühlkörper bei manchen Ausführungsformen so ausgestaltet werden kann, dass die Bereiche mit thermisch höherer Belastung flüssig gekühlt werden, während die Bereiche mit thermisch geringerer Belastung gasförmig, bspw. luftgekühlt sein können. Dadurch ist eine individuelle und flexible Anpassung an die jeweiligen Kühlanforderungen möglich.

Eine Leiterplatteneinheit, wie oben erwähnt, umfasst beispielsweise eine Leiterplatte (die bei manchen Ausführungsformen nicht durchgehend ist) und kann bspw. mit einem oder mehreren Kühlkörpern der Hybrid-Kühlung verbunden werden. Auf der Leiterplatte sind oberflächenmontierbare Bauelemente, sogenannte SMD (Surface Mounted Device) Bauelemente, aufgelötet. Die SMD-Technik zeichnet sich dadurch aus, dass Bauelemente direkt auf eine Leiterplatte aufgelötet werden können. Bei manchen Ausführungsformen befinden sich insbesondere SMD-Bauelemente, die eine starke Wärmeleistung produzieren, in Wärmeleitungsbereichen der Leiterplatte. Derartige Bauelemente werden im Folgenden auch als (oberflächenmontierbare) Leistungselemente bezeichnet. Die Wärmeleitungsbereiche sind Bereiche mit erhöhter Wärmeleitfähigkeit, die bspw. dadurch erreicht wird, dass sich in den Wärmeleitungsbereichen metallisierte Durchgangsbohrungen befinden. Die Durchgangsbohrungen bilden metallische Durchkontaktierungen zur Wärmeleitung, die eine entsprechende Wärmeleitfähigkeit bereitstellen und daher Wärme von den Leistungselementen ableiten können. Folglich kann bspw. durch die Anzahl, die Form, die Größe des Durchmessers der Bohrungen, der Art des Materials bzw. der Metallisierung die Wärmeleitfähigkeit entsprechend verändert werden. Unter- und/oder oberhalb der Wärmeleitungsbereiche befindet sich eine thermisch leitende und elektrisch isolierende Schicht, bspw. eine Keramikisolation, die aus Aluminiumoxid oder Aluminiumnitrid hergestellt sein kann (Die Schicht ist bei manchen Ausführungsformen nicht direkt auf der Leiterplatte angeordnet, sondern es können sich auch andere Schichten dazwischen befinden. Die Schicht ist jedoch bei manchen Ausführungsformen wenigstens so (in der der Nähe der Wärmeleitungsbereiche) angeordnet, dass sie wenigstens einen Teil der durch bspw. das Leistungselement entstehenden Wärme zu dem Kühlkörper leitet.). Der Wärmeleitpfad ist folglich in manchen Ausführungsformen von dem Leistungselement durch die Durchkontaktierung zu der thermisch leitenden, aber elektrisch isolierenden Schicht. Die thermisch leitende und elektrisch isolierende Schicht steht wiederum in Kontakt mit einem oder mehreren Kühlkörper der Hybrid-Kühlung. Um nun den entsprechenden Wärmeleitungskontakt zwischen dem Leistungselement, den Durchkontaktierungen und der thermisch leitenden und elektrisch isolierenden Schicht herzustellen, presst bspw. ein elastischer Clip Bauelemente, wie bspw. SMD-Bauelemente und insbesondere SMD-Leistungselemente, derart gegen den oder die mehreren Kühlkörper, dass die von den Leistungselementen erzeugte Wärme über die Durchkontaktierungen zu dem(/n) Kühlkörper(n) abgeleitet wird. Der Anpressdruck durch den elastischen Clip ist dabei derart ausgebildet, dass er auch zusätzlich eine Haltefunktion erfüllen kann. Außerdem ist durch die Elastizität des Clips bspw. gewährleistet, dass - im Gegensatz zu bspw. Schraubverbindungen - der Anpressdruck nicht nach längerer Zeit, bspw. durch Materialermüdung, Erschütterungen und dergleichen, nachlässt.

Die Clips können aus jedem elastischen Material hergestellt werden und haben eine Form, bspw. eine S-artige Form, die die Elastizität und damit auch den Anpressdruck unterstützt. Bei manchen Ausführungsformen ist der Clip mit einem Ende, bspw. in einer Ausnehmung, in dem Kühlkörper befestigt. Das andere Ende des Clips drückt dann bspw. auf ein Leistungselement auf der Leiterplatteneinheit, so dass dieses auf den Wärmeleitungsbereich der Leiterplatte gepresst wird - d.h. ein Anpressdruck erzeugt wird - und zusammen mit dem Wärmeleitungsbereich auf die thermisch leitende und elektrisch isolierende Schicht gepresst wird (oder umgekehrt auf die elektrisch isolierende Schicht und dann auf die Leiterplatte), welche folglich auf eine Fläche des Kühlkörpers gepresst wird. Das eine Ende übt folglich an einem seiner Enden einen Anpressdruck auf das Leistungselement, den Wärmeleitungsbereich mit seinen Durchkontaktierungen der Leiterplatte, die thermisch leitende und elektrisch isolierende Schicht und schließlich auf eine Fläche des Kühlkörpers aus. Das andere Ende des Clips ruht dabei in manchen Ausführungsbeispielen in dem Aufnahmebereich des Kühlkörpers.

Der Aufnahmebereich des Kühlkörpers, der ein Ende des Clips aufnehmen kann, weist bei manchen Ausführungsformen ein Oberflächenprofil auf einer Fläche auf, das geeignet ist, die Reibung zwischen einer seiner Oberflächen und eines aufgenommenen Teils des Clips, bspw. einer Kante des Endes des Clips stark zu erhöhen. Bei manchen Ausführungsformen ist das Oberflächenprofil bspw. gezackt oder geriffelt ausgebildet, d.h. es weist Erhebungen und Vertiefungen auf, in die sich beispielsweise eine Kante des Endes des Clips wenigstens teilweise verhaken kann. Bei manchen Ausführungsformen weist eine Oberfläche des Aufnahmebereiches einen Vorsprung auf, der bspw. ein Ende des Clips davon abhält, aus dem Aufnahmebereich herauszurutschen. Bei manchen Ausführungsformen liegt beispielsweise ein gebogener Bereich des Clips an einer Oberfläche des Aufnahmebereichs an und folglich ist in manchen Ausführungsformen der gebogene Bereich mit einem Oberflächenprofil versehen, das geeignet ist die Reibung zu erhöhen. Die Oberfläche des Aufnahmebereiches des Kühlkörpers weist bei manchen Ausführungsformen ein entsprechendes Profil auf, um die Reibung weiter zu verstärken und ein entsprechendes Herausgleiten des Clips aus dem Aufnahmebereich zu verhindern oder wenigstens zu erschweren.

Der Aufnahmebereich des Kühlkörpers befindet sich bei manchen Ausführungsformen seitlich der Leiterplatte und ist bspw. als Vertiefung in dem Kühlkörper ausgebildet. Der Kühlkörper geht folglich - im Querschnitt gesehen - L-artig um die Leiterplatte herum.

Die Wärmeleitungsbereiche der Leiterplatte mit den Durchkontaktierungen und die Leistungselemente, d.h. die Bauelemente mit hoher thermischer Last, befinden sich in Randzonen bzw. Randbereichen der Leiterplatte. Der Clip, der bspw. in einem seitlichen Aufnahmebereich des Kühlkörpers sitzt oder dort verankert ist, erstreckt sich dann in diese Randbereich herein und übt - wie oben ausgeführt - den Anpressdruck auf das Leistungselement aus. Die Leistungselemente können sich auch in der Mitte der Leiterplatte befinden, sodass sich der Clip bis in diesen Mittenbereich erstreckt und dort den Anpressdruck ausübt.

Bei manchen Ausführungsformen ist der Clip so ausgebildet, dass er - bspw. als Dreibein - nicht nur Anpressdruck auf ein Bauelement, sondern auch auf zwei (oder mehr) Bauelemente ausüben kann.

Manche Ausführungsformen basieren bspw. auf der Nutzung der elastischen Verformung von Metallteilen. Es werden einerseits bekannte elastischen Clips für die Erzeugung eines Anpressdruckes zwischen einer Wärmequelle und einer Wärmesenke verwendet und andererseits dünnwandige, metallische Kühlrohre in Kanäle unter elastischer Deformation in den Kühlkörper eingepresst, um einen dauerhaft guten Wärmeübergang zu gewährleisten. Die Kühlrohre sind bei manchen Ausführungsformen beispielsweise aus Federstahl hergestellt.

Eine Delaminierung durch Störfälle mit Übertemperatur wird durch den elastischen Anpressdruck des elastischen Clips folglich bei manchen Ausführungsformen zumindest teilweise wirksam verhindert.

Bei einem Verfahren zur Herstellung einer Leitplatteneinheit können SMD-Bauelemente zuerst in einem Arbeitsgang maschinell auf die Leiterplatte montiert und gelötet werden. Leistungselemente mit hoher thermischer Last werden bei manchen Ausführungsformen bevorzugt in den Randzonen der Leiterplatte platziert. Unter oder über der Leiterplatte in diesen Randzonen werden thermisch gut leitende und elektrisch isolierende Schichten, wie bspw. Isolationselemente angeordnet. Die Isolationselemente sind bei manchen Ausführungsformen aus Keramik wie Al₂O₃ (Aluminiumoxid) oder AIN (Aluminiumnitrid) hergestellt. Das Leistungselement, das auf dem Wärmeleitungsbereich der Leiterplatte angeordnet ist, wird bspw. mit einem Clip auf einen oder mehrere Kühlkörper, z.B. auf speziell geformte Kühl(körper)profile, gepresst.

Bei manchen Ausführungsformen kann durch einfaches Austauschen der Kühlprofile bzw. Kühlkörper oder durch zusätzliche Montage von Kühlrohren, zwischen Flüssigkeitskühlung und/oder Luftkühlung gewählt werden bzw. die Kühlleistung entsprechend angepasst werden.

Bei manchen Ausführungsformen führt die kombinierte Flüssigkeits-/Luftkühlung zu einer neuartigen, erheblich robusteren Bauart, welche beim Totalausfall eines oder bei einem Teilausfall beider Kühlmedia den Betrieb aufrechterhalten kann.

Bei manchen Ausführungsformen werden die Kühlkörper in Abhängigkeit der abzuleitenden Wärmemenge ausgestaltet und die Abfuhr der Wärme nur durch Kühlflüssigkeit oder nur durch Kühlluft oder durch eine Kombination aus Kühlflüssigkeit und Kühlluft bewirkt.

Bei manchen Ausführungsformen weisen äußere Bereiche der Kühlkörper Kühlrippen auf und zwischen den Kühlrippen sind bspw. dünnwandige Kühlrohre unter elastischer Deformation eingepresst und die Abfuhr der Wärme ist über ungefilterte Kühlluft und eine Kühlflüssigkeit vorgesehen.

Bei manchen Ausführungsformen wird der Innenraum eines Moduls bzw. einer Leiterplatteneinheit zum Schutz der Elektronikbauteile vor Umwelteinflüssen, vollständig mit Deckblechen verschlossen. Diese dienen bei manchen Ausführungsformen zusätzlich zur Kühlung und auch zur Verhinderung der Abstrahlung von elektromagnetischen Emissionen.

Manche Ausführungsformen eignen sich für den direkten Einbau in Werkzeugmaschinen und für ähnliche leistungselektronische Anwendungen, insbesondere aber für den direkten Einbau in Funkenerosionsmaschinen. Dank dem hohen Integrationsgrad und der effizienten Wärmeabfuhr durch die Hybrid-Kühlung können die Leistungsmodule so miniaturisiert werden, dass sie sich in einer beliebigen, optimalen Position in den Maschinen einbauen lassen. So werden zum Beispiel die Impulseigenschaften von Erosionsgeneratoren, dank der wegfallenden Hochfrequenz-Verkabelung, bedeutend verbessert. Die Leistungsmodule können ohne große Mehrkosten dicht gebaut werden, und ertragen so auch die rausten Umgebungsbedingungen. Zudem weisen die Module nur eine äußerst geringe Wärme-und elektromagnetische Abstrahlung auf - Eigenschaften, welche für einen Direkteinbau in eine Maschine vorteilhaft sind.

Ein weiterer Vorteil ergibt sich bei manchen Ausführungsformen durch die Aufteilung in eine Leiterplatte mit SMD-Leistungselementen und eine Leiterplatte mit SMD-Steuerelementen, weil bspw. dadurch die beiden Leiterplatten eine unterschiedliche Anzahl Leiterebenen und/oder unterschiedliche Leiterdicken aufweisen können. Dies ergibt erstens einen zusätzlichen Freiheitsgrad, um die Leiterplatten besser auf die Anwendung optimieren zu können, und zweitens können Treiber- und Steuersignale dank diesem Prinzip am richtigen Ort und auf kürzestem Weg zwischen der Steuerplatte und der Leistungsplatte über SMD- Steckverbinder verbunden werden. Da beliebig viele solcher Baueinheiten miteinander kombiniert werden können, sind auch System-Pakete mit sehr hoher Leistungsdichte möglich. Dazu weisen manche Ausführungsformen Kühlkörper mit bestimmten Ausformungen auf, so dass die Leistungsmodule mit der Hybrid-Kühlung zusammen als Baueinheiten miteinander kombiniert werden können.

Manche Ausführungsformen ermöglichen die Anwendung von modernen automatischen Fertigungsmethoden für die Massenherstellung der Leistungsmodule bzw. Leiterplatteneinheiten, was zu einer namhaften Kostenreduktion und gleichzeitig zu einer hohen und reproduzierbaren Fertigungsqualität führt. Die Endmontage, Test und Wartung der Leistungsmodule kann im internationalen Umfeld und sogar in einfacheren Werkstätten erfolgen. Die SMT-Fertigungsmethode (SMT: Surface Mount Technology) basiert auf der automatischen Bestückung von unbedrahteten SMD-Bauelementen (SMD: Surface Mounted Devices) auf Leiterplatten, welche keine Bohrungen mehr für die Aufnahme von Drahtanschlüssen aufweisen. Durch die einfache Anbringung des Kühlkörpers der Hybrid-Kühlung durch die oben erwähnten Clips ist es folglich möglich, die Kühlung von entsprechend auf Leiterplatten montierten SMD-Bauelementen einfach vorzunehmen.

Daraus ergibt sich ein bei manchen Ausführungsformen ein weiterer Vorteil am Ende der Produktlebensdauer. Zur Trennung von Elektronikschrott und mechanischen Teilen werden die elastischen Clips entfernt, sodass bspw. der Kühlkörper von der Leiterplatte getrennt werden kann, dann werden die Leiterplatten entnommen und über den Schmelzpunkt des Lotes erwärmt, wodurch sich danach alle elektronischen Komponenten einfach abwischen lassen.

Dies wird bei manchen Ausführungsformen dadurch erreicht, dass die Hybrid-Kühlung dank ihrer modularen Eigenschaft direkt am Wirkungsort angebracht werden kann, ohne dass es zu einem negativen Wärmeeinfluss der Luft- oder Flüssigkeitskühlung auf die Maschinenstruktur kommt.

Manche Ausführungsformen der Erfindung betreffen einen modularen Aspekt. So ist bei manchen Ausführungsformen der Kühlkörper so ausgebildet, dass er positive und negative Ausformungen aufweist, die ineinandergreifen können. Diese Ausformungen können bspw. eine konvexe bzw. konkave Form haben. Diese positiven und negativen Ausformungen greifen bspw. ineinander, wenn die Leiterplatteneinheiten, an denen sich die Kühlkörper der Hybrid-Kühlung befinden, aufeinander gestapelt werden. Dadurch verbessert sich die Wärmeleitung von einer Leiterplatteneinheit zur anderen bzw. von einem Kühlkörper zum nächsten, sodass bspw. thermisch weniger belastete Leiterplatteneinheiten mit ihren Kühlkörpern und thermisch stärker belastete Leiterplatteneinheiten mit ihren Kühlkörpern untereinander Wärme austauschen können und sich so insgesamt die Kühlwirkung verbessert.

Durch die Ausformungen an den Kühlkörpern sind bei manchen Ausführungsformen Leiterplatteneinheiten mit derartigen Kühlkörpern stapelbar und können dadurch bspw. ein System-Paket bilden. Dabei können mehrere Leistungsmodule bzw. Leiterplatteneinheiten durch einfaches Ineinanderschieben oder Einrasten der entsprechenden Ausformungen der Kühlkörper zu Systempaketen vereinigt werden.

Folglich realisieren manche Ausführungsformen ein Gesamtkonzept für den Aufbau und den Betrieb von Leistungsmodulen mit integrierter Kühlung.

Bei manchen Ausführungsformen umfasst ein Verfahren zum Kühlen einer Leiterplatteneinheit für eine Werkzeugmaschine die Kühlung eines Kühlkörper, der Wärme von wenigstens einem oberflächenmontierbaren Leistungselement, das auf der Leiterplatteneinheit angeordnet ist, aufnimmt, sowohl durch ein flüssiges als auch ein gasförmiges Kühlmedium. Bei manchen Ausführungsformen wird dabei als flüssiges Kühlmedium das die Arbeitsflüssigkeit (z.B. Kühlflüssigkeit) einer Werkzeugmaschine, insbesondere das Dielektrikum einer Funkenerosionsmaschine, verwendet.

Zurückkehrend zu Fig. 1 werden dort SMD-Leistungselemente 1 und SMD-Steuerelemente 17 bei einer automatisch auf einer Leiterplatte 2 platziert und gelötet, wobei die thermisch belasteten SMD-Leistungselemente 1 in Randzonen der Leiterplatte 2 angeordnet werden, wo die Kühlkörperprofile 4 die Wärme abführen können. Bei dieser Ausführungsform ist keine Flüssigkeitskühlung gezeigt - alle Ausführungen im Zusammenhang mit dieser Ausführungsform sollen aber auch für die nachfolgenden Ausführungsformen mit der Hybrid-Kühlung gelten und stellen folglich allgemeine Erläuterungen zu den Ausführungsformen dar. Bei den nachfolgenden Ausführungsformen ist die Hybrid-Kühlung jeweils in Kombination mit einem Leistungsmodul gezeigt, wobei Teile des Leistungsmoduls auch zur Hybrid-Kühlung zuzurechnen sind. Bei manchen Ausführungsformen umfasst die Hybrid-Kühlung praktisch die gesamte Leiterplatteneinheit bzw. das Leistungsmodul - oder zumindest die Teile, die für die Wärmeleitung ab der Wärmequelle (bspw. SMD-Leistungselement) erforderlich sind.

In diesen Randzonen ist unter den SMD-Leistungselementen 1 eine Vielzahl von metallisierten Bohrungen für eine verbesserte Wärmeleitung angebracht. Zwischen diesen Randzonen der Leiterplatte 2 und dem Kühlkörperprofil 4 wird eine Keramikisolation 3 eingefügt, welche beidseitig eine Beschichtung mit einer Wärmeleitpaste aufweist. Man könnte anstelle der Keramikisolation 3 auch eine bekannte pulvergefüllte Polymerfolie verwenden, dies würde aber zu höheren Streukapazitäten und damit zu elektrischen Stör- Problemen führen.

Jedes Leistungselement 1 wird nun mit einem elastischen Clip 5, eine speziell geformte Blattfeder angepasster Stärke und Breite, über die Leiterplatte 2 und die Keramikisolation 3 gegen das Kühlkörperprofil 4 gepresst, und bekommt dadurch einen zuverlässigen Wärmekontakt mit dem Kühlkörperprofil 4.

Das Kühlkörperprofil 4 und der Clip 5 werden beispielsweise von der Firma AAVID THERMALLOY (www.aavidthermallov.com) angeboten. Diese Firma offeriert neu auch Spezialausführungen von Kühlkörperprofilen 4 mit eingelöteten Edelstahlrohren für die Flüssigkeitskühlung von bedrahteten Leistungselementen.

Als Material für die Keramikisolation 3 eignet sich beispielsweise Aluminiumnitrid (AIN) mit einem thermischen Leitwert von 180W/mK besonders gut, aber auch das verbreitete und weit billigere Aluminiumoxyd (Al₂O₃) mit einem thermischen Leitwert von 24W/mK kann durchaus genügend sein. Berylliumoxyd (BeO) mit dem thermischen Leitwert von 260W/mK wäre zwar sehr interessant, kann aber wegen seiner hohen Giftigkeit in Staubform bei manchen Ausführungsformen nicht verwendet werden. Die elektrische Durchschlagsfestigkeit liegt für alle diese Keramikarten bei ausgezeichneten 10 bis 20 kV/mm, und ist für unsere Anforderungen mehr als ausreichend. Die relative Dielektrizitätskonstante ε_{R} zwischen 6.5 und 8.5 ist bei manchen Ausführungsformen eher ausschlaggebend für die Wahl des Materials und Dicke der Keramikisolation 3.

Materialien für die Keramikisolationen 3 bietet beispielsweise die Firma DENKA (www.denka.co.jp) an.

Versuche haben gezeigt, dass man mit dieser Ausführungsform bei einer Stärke der Leiterplatte 2 von 0.8mm und Aluminiumoxyd-Keramikisolationen 3 von 0.6mm Dicke, für eine SMD-Gehäuseform D2PAK eine maximale Verlustleistung von 30W und für eine SMD-Gehäuseform D3PAK eine maximale Verlustleistung von 50W unter realistischen Betriebsbedingungen abführen kann. Die entsprechenden Gehäuseformen für bedrahtete Bauelemente TO220 und TO247 erlauben kaum diese Werte. Dieser Fortschritt gestattet eine sehr kompakte Bauweise der Module.

Geringere Stärken der Leiterplatte 2 und Aluminiumnitrid-Keramikisolationen 3 lassen bei manchen Ausführungsformen noch höhere Verlustleistungen zu. Es gibt aber bestimmte Grenzen für die Belastbarkeit der SMD-Bauteile selbst, oberhalb jener die Zuverlässigkeit wegen den Temperaturzyklen generell abnimmt. In diesem Bereich kann eine Reduktion der Bauteiltemperatur um 10°C eine Verdoppelung der Lebensdauer bedeuten.

Die Kontaktflächen für die harten und spröden Keramikisolationen 3 müssen bei manchen Ausführungsformen absolut eben sein, d.h., dass die Leiterplatte 2 nach dem Lötprozess eventuell auf der Rückseite nachbearbeitet werden muss oder, dass ein ungenau extrudiertes Kühlkörperprofil 4 eventuell eine Nachbearbeitung braucht. Je nach Dicke der Leiterplatte 2 kann es auch bei manchen Ausführungsformen vorteilhaft sein, die Leiterplatte 2 zwischen SMD-Leistungselementen 1 mit Schlitzen oder Einkerbungen zu versehen, um ein planes Aufliegen auch bei einer leicht verbogenen Leiterplatte 2 zu garantieren.

Versuche haben gezeigt, dass sich alle Wärmeübergangswiderstände nach einer gewissen Betriebszeit generell reduzieren, was zu tieferen Temperaturen auf den SMD-Bauelementen führt. Um diesen vorteilhaften Zustand sofort zu erreichen und dies ohne Schäden an SMD-Bauelementen anzurichten, werden bei manchen Ausführungsformen die Module nach der Montage mit einer Wärmebehandlung stabilisiert.

Die thermisch weit weniger belasteten SMD-Steuerelemente 17, wie Prozessoren oder Logikschaltungen, können die Wärme ebenfalls abgeben: durch die Leiterplatte 2 hindurch über eine erste Wärmeleitfolie 6 und ein Bodenblech 7, welches mit Schrauben 8 mit den Kühlkörperprofilen 4 verbunden ist. Für diese SMD-Steuerelemente 17 ist der eher geringe thermische Leitwert von etwa 0.3W/mK der Leiterplatte 2 schon ausreichend für den Wärmetransport auf die Wärmeleitfolie 6.

Solche flexible Wärmeleitfolien 6 können beispielsweise aus einem Produkt GAP PAD A2000 von der Firma BERGQUIST (www.bergauistcompany.com) bestehen.

Fig. 5 zeigt eine erste Ausführungsform einer Hybrid-Kühlung einer Flüssigkeitskühlung und Luftkühlung. Die Kühlkörperprofile 4 sind dazu mit einem U-förmigen Kanal 9 versehen, welcher geringfügig schmäler ist, als die dünnwandigen Kühlrohre 10 im Durchmesser sind. Das Bodenblech 7 drückt über Schrauben 8 die Kühlrohre 10 in die U-förmigen Kanäle 9. Dadurch werden die Kühlrohre 10 elastisch deformiert, und stehen darum in dauerhaftem, engem thermischen Kontakt mit den Kühlkörperprofilen 4.

Die Kühlrohre 10 wählt man je nach verwendeter Kühlflüssigkeit aus Kupfer, Aluminium, deren Legierungen oder Edelstahl. Die Werkstoffe müssen möglichst hart sein, um die erwünschte Federwirkung zu erzeugen. Die Werkstoffe sollen nicht etwa plastisch deformiert werden, denn bei Wärmeschrumpfungen würden sich plastische Deformationen irreversibel verhalten.

Die typische Wandstärke der Kühlrohre 10 beträgt bei dieser Ausführungsform etwa 0.2mm bis 1 mm. Die Kühlrohre 10 werden über Anschlussstücke (nicht gezeichnet) und/oder Schläuche (nicht gezeichnet) mit einem Kühlsystem (nicht gezeichnet) verbunden.

Die Durchflussgeschwindigkeit der Kühlflüssigkeit wählt man in der Kühlzone bei manchen Ausführungsformen für eine effiziente Kühlung so hoch, dass eine turbulente Strömung, und dadurch eine gute Durchmischung der Kühlflüssigkeit auftritt. Dazu muss die so genannte Kritische Reynoldszahl von 2320 überschritten werden. Für Wasser als Kühlflüssigkeit und bei einem Kühlrohr-Innendurchmesser von 5mm muss dafür die Durchflussgeschwindigkeit beispielsweise größer als 0.5m/s bei 20°C sein. In den übrigen Zonen, wie bspw. bei den Schläuchen und Anschlüssen, wählt man hingegen größere Querschnitte, um bei einer laminaren Strömung geringere Strömungsverlusten zu erzielen.

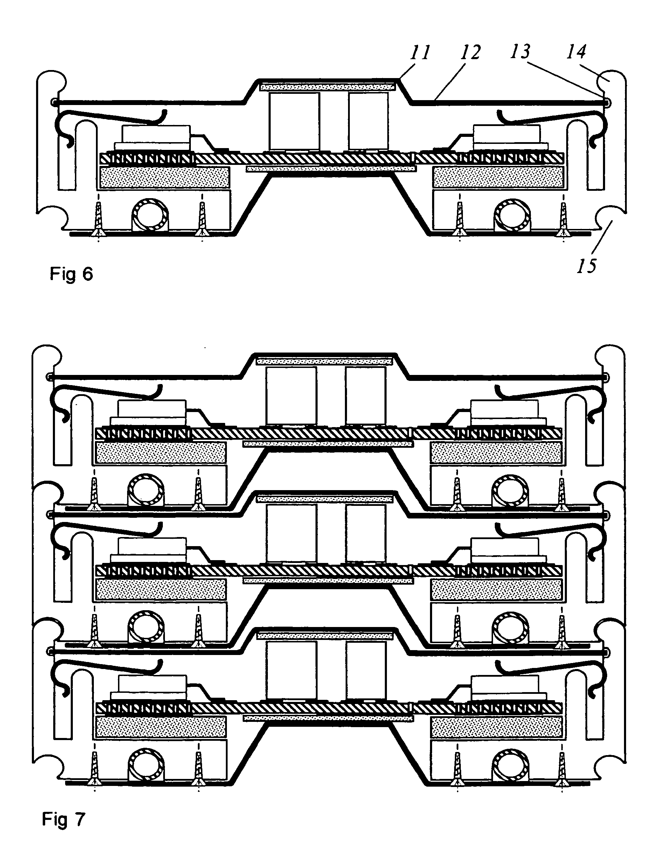

Ausführungsformen nach den folgenden Fig. 6 bis Fig. 21 können, wie auch die Ausführungsform nach Fig. 5, beliebig mit ungefilterter Kühlluft und/oder einer Kühlflüssigkeit gekühlt werden. In Erosionsmaschinen sind meistens schon Einrichtungen für Flüssigkeitskühlung vorhanden, um die Dielektrika auf konstanter Temperatur zu halten. Folglich kann es bei manchen Ausführungsformen preisgünstig sein, diese etwas größer auszulegen, um auch die Elektronikmodule zu kühlen. Bei manchen Ausführungsformen zirkuliert die Kühlflüssigkeit der Kühleinrichtung oder auch das gekühlte Dielektrikum der Erosionsmaschine über die Module direkt.

Beim direkten Einbau in eine Maschine, wird bei manchen Ausführungsformen bei der Luftkühlung darauf geachtet, dass die erhitzte Abluft nicht mit der Maschinenstruktur in Kontakt kommt, sondern über eine kaminförmige Einrichtung nach oben abgegeben wird. Bei stark verschmutzter Kühlluft werden die Kühlflächen der Module bei manchen Ausführungsformen regelmäßig gereinigt, um die Kühlwirkung zu garantieren. Dies ist für viele Anwender billiger und einfacher, als Luftfilter auszutauschen.

Die Kombination von Luftkühlung und Flüssigkeitskühlung kann in tropischen Ländern besonders vorteilhaft sein, wo die Umgebungstemperatur in den Werkstätten nicht selten 45°C übersteigt. Mit einer geringen zusätzlichen Flüssigkeitskühlung kann eine solche Maschine, die normalerweise abgeschaltet werden müsste, nun mit voller Leistung weiter produzieren.

Fig. 6 zeigt ein Deckblech 12, das die Module gegen Umwelteinflüsse abschirmt und eine Art Verzahnung, die durch konvexe Ausbildungen 14 und konkave Ausbildungen 15 der Kühlkörperprofile 4 gebildet ist und folglich die Module stapelbar macht. Die Module können, so wie in Fig. 7 dargestellt, ineinander geschoben oder eingerastet werden. Stirnseitig, beidseitig angebrachte Deckbleche (nicht gezeichnet) oder Abschlüsse (nicht gezeichnet) verleihen den Modulen einen geschützten Innenraum und eine gute mechanische Stabilität.

Das Deckblech 12 kann zusätzlich über zweite Wärmeleitfolien 11 Abwärme von der Oberseite von SMD-Bauelementen abführen. Das Deckblech 12 steht dafür über eine Einkerbung 13 in thermischem Kontakt mit den Kühlkörperprofilen 4. Auch hier wird die Elastizität des Deckbleches 12 für einen dauerhaft geringen thermischen Übergangswiderstand ausgenützt.

Bei manchen Ausführungsformen, bei welchen die Deckbleche 12 keine Wärme ableiten müssen, können diese in Systemen wie nach Fig. 7, mit Ausnahme des obersten Moduls, weggelassen werden.

Um hohe Verlustleistungen abführen zu können, wird bei manchen Ausführungsformen die Leiterplatte 2 dünn ausgeführt, weil die Temperaturdifferenz zwischen SMD-Leistungselement 1 und Keramikisolation 3 proportional zur Leiterplattendicke ansteigt. Dies hat aber als Konsequenz, dass die mechanische Stabilität der Leiterplatte 2 bei manchen Ausführungsformen ungenügend werden kann.

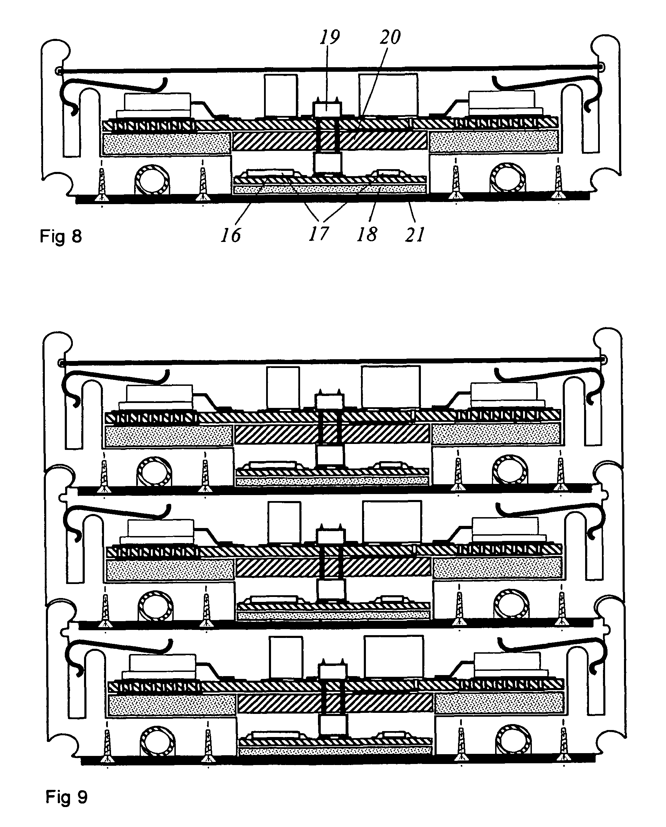

Die in Fig. 8 dargestellte Ausführungsform weist daher eine Verstärkungsplatte 20 auf der Rückseite (auf der Seite ohne SMD- Bauelemente) der Leiterplatte 2 auf.

Die Verstärkungsplatte 20 kann zusammen mit den Keramikisolationen 3 über so genannte Prepregs mit der Leiterplatte 2 vereint werden. Dieses Verfahren ist bekannt, und z.B. in der Patentanmeldung EP 06 02 2498 eingehend beschrieben.

Alternativ wird die Leiterplatte 2 mit der Verstärkungsplatte 20 und den Keramikisolationen 3 bei manchen Ausführungsformen auch verlötet, was besonders geringe Wärmeübergangswiderstände ergibt. Dazu müssen sowohl die Verstärkungsplatte 20 als auch die Keramikisolationen 3 an geeigneten Stellen eine Kupferbeschichtung aufweisen. Kupferbeschichtete Keramikisolationen 3 können ebenfalls von der erwähnten Firma DENKA, oder von der Firma CURAMIK ELECTRONICS (www.curamik.com) bezogen werden.

Bei einigen der bisher beschriebenen Ausführungsformen wird nur eine Leiterplatte 2 pro Modul benötigt. Dies verlangt aber nach Kompromissen und ist daher für Hochleistungs-Anwendungen weniger geeignet.

Die Ausführungsform nach Fig. 8 zeigt darum weiter, wie man die SMD-Steuerelemente 17 von der Leiterplatte 2 auf eine Steuerplatte 16 auslagern kann. Dazu werden die Leiterplatte 2 und die Steuerplatte 16 an geeigneten Stellen mit SMD-Steckverbindern 19 verbunden. In diesem Fall genügen für die Leiterplatte 2 meistens zwei Leiterebenen mit Hochstrom-Leiterbahnen, welche mit Durchkontaktierungen verbunden sein können. Hochstrom-Leiterbahnen decken typisch einen Bereich von 5 Ampere bis 200 Ampere ab, und werden bei manchen Ausführungsformen in Leiterdicken auch bis über 200µm ausgeführt.

Die Steuerplatte 16 kann hingegen bei manchen Ausführungsformen mit beliebig vielen Leiterebenen und in Feinleitertechnik ausgeführt werden, da hier keine großen thermischen Probleme oder hohe Ströme vorliegen. Die Steuerplatte 16 kann über eine selbstklebende Wärmeleitfolie 18 mit einem verstärkten Bodenblech 21 verbunden werden. Das verstärkte Bodenblech 21 leitet dann die Wärme auf die Kühlkörperprofile 4 ab.

Für die selbstklebende Wärmeleitfolien 18 kann beispielsweise das Produkt THERMATTACH T413 der Firma CHOMERICS (www.chomerics.com) verwendet werden. Dieses Material hat einen thermischen Leitwert von nur 0.35W/mK, was in diesem Fall aber ausreichend ist. Bei einer Reparatur kann diese Klebeverbindung mit einem Spachtel gelöst werden, muss jedoch bei einer erneuten Montage bei manchen Ausführungsformen nach der Reinigung der Klebeflächen durch eine neue Folie ersetzt werden.

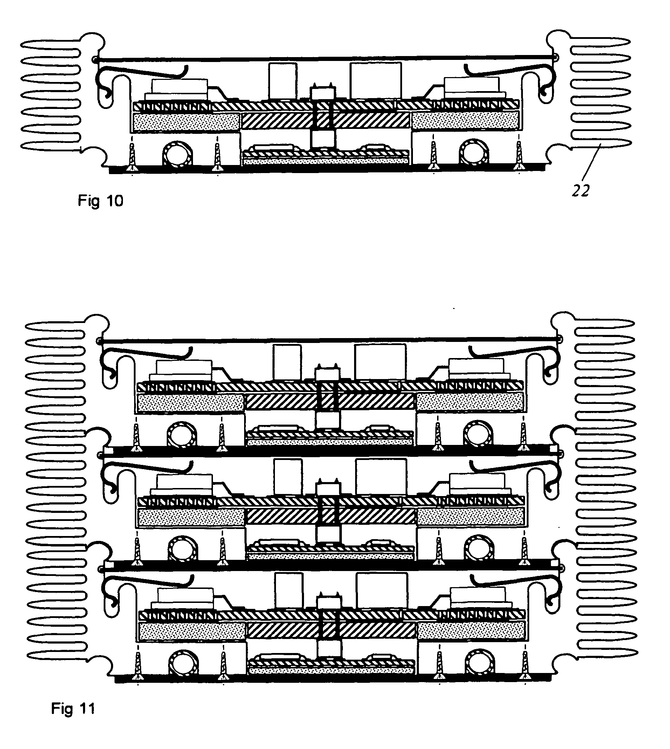

Fig. 10 zeigt eine modifizierte Ausführungsform eines Moduls nach Fig. 8, mit dem Ziel, die Kühlleistung für die Luftkühlung zu erhöhen. Die Kühlkörperprofile 4 sind dafür mit zusätzlichen Kühlrippen 22 versehen. Die dadurch vergrößerte Oberfläche reduziert den Wärmeübergangs-Widerstand zwischen Kühlkörperprofil 4 und Kühlluft.

Fig. 11 zeigt beispielhaft eine Ausführungsform eines System-Pakets aus solchen Modulen. Soll die Kühlung ausschließlich über Kühlluft erfolgen, ist es bei manchen Ausführungsformen vorteilhaft die U-förmigen Kanäle 9 und die Kühlrohre 10 wegzulassen.

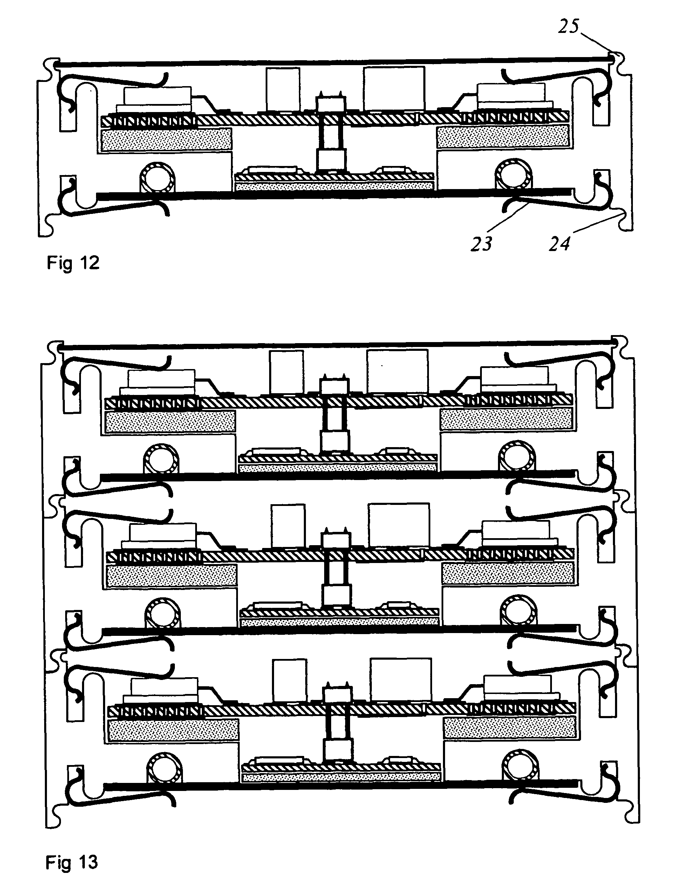

Fig. 12 zeigt eine weitere Ausführungsform der Erfindung. Zur Erleichterung der Montage und Demontage des Moduls, sind die Schrauben 8 ebenfalls durch Clips 23 ersetzt, welche identisch zu den Clips 5 für die SMD-Leistungselemente 1 bei manchen Ausführungsformen sind. Dadurch ergibt sich eine erhöhte Toleranz für Wärmedehnungen, da die Clips 23 elastischer sind als Schraubverbindungen und entsprechend eine Verlängerung der Lebensdauer des Moduls bewirken können.

Die Verzahnung der Module ist mit positiven Ausformungen 24 und dazu negativen Ausformungen 25 der Kühlkörperprofile 4 hier so modifiziert, dass Platz für die Aufnahme der Clips 23 vorhanden ist und die Bauhöhe der Module niedrig gehalten werden kann.

Fig. 13 zeigt anhand eines System-Pakets aus den Modulen nach Fig. 12, wie die Ausformungen 24 und 25 ineinandergreifen und eine entsprechende Wärmeleitung von einem Modul zum Nächsten ermöglichen.

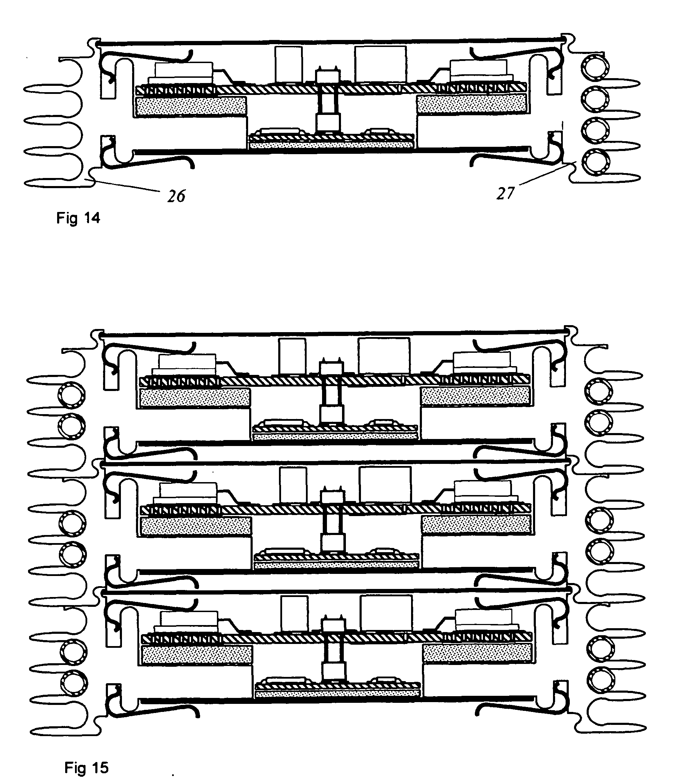

Fig. 14 zeigt eine Ausführungsform, die einen weiteren Schritt in Richtung Flexibilität für die Anwendung der Module macht. Sofern man gleiche Kühlkörperprofile 4 für Flüssigkeits- oder Luftkühlung verwenden möchte, stören im Falle ausschließlicher Luftkühlung die U-förmigen Kanäle 9 nach den Fig. 5 bis 13 den Wärmefluss zwischen den SMD- Leistungselementen 1 und der Kühlfläche für die Luftkühlung. Um diesen Nachteil zu beseitigen, werden in dieser Ausführungsform die Sitze der Kühlrohre 10 zwischen die Kühlrippen verlegt. Die Sitze sind so geformt und dimensioniert, dass die Kühlrohre 10 rein durch ihre elastische Deformation infolge Einpressens - also hier ohne zusätzliche Hilfsmittel - festsitzen. Fig. 14 zeigt beispielhaft das Kühlprofil 26 ohne Kühlrohre 10 (bei ausschließlicher Luftkühlung), und das identische Kühlprofil 27 mit Kühlrohren 10 (für Flüssigkeits- und / oder Luftkühlung).

Fig. 15 zeigt am Beispiel einer Ausführungsform eines System-Paketes, dass je nach Anforderung die Kühlrohre 10 auch nur teilweise eingesetzt werden können. Durch die Anzahl der Kühlrohre kann die Kühlleistung entsprechend modifiziert werden.

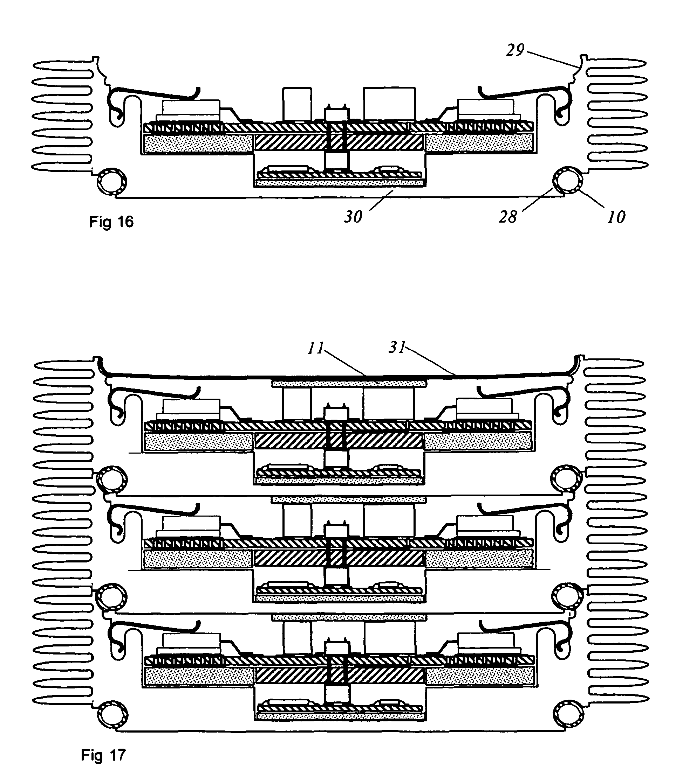

Fig. 16 zeigt ein weitere Ausführungsform für denselben Zweck. Hier sind die Kühlrohre 10 in den Bereichen angebracht, wo teilweise bei den vorhergehenden Ausführungsformen die Verzahnungen für die Stapelung der Module waren. Auf der Unterseite des Kühlkörperprofils 4 ist ein erster Kanal 28 vorgesehen, welcher so gestaltet ist, dass die Kühlrohre 10 wie nach Fig. 14 ohne zusätzliche Hilfsmittel nach dem Einpressen festsitzen. Auf der Oberseite ist ein zweiter Kanal 29 vorgesehen, welcher so ausgebildet ist, dass die Kühlrohre 10 des zu stapelnden Moduls zusätzlich elastisch verformt werden, um die Module zusammenzuhalten und um einen guten Wärmeübergang zwischen den Kühlrohren 10 und beiden gestapelten Modulen zu garantieren. Um die seitlichen Kräfte infolge der Deformation der Kühlrohre 10 besser aufnehmen zu können, wird bei dieser Ausführungsform bevorzugt ein einteiliger Kühlkörper 30 verwendet.

Zur Stapelung der Module kann man diese vertikal zusammenpressen, und einrasten lassen, oder längs zusammenschieben, wobei man die Kanäle 29 in diesem Fall auch mit einer größeren Umfassung ausbilden kann.

Als dritte Möglichkeit kann man bei manchen Ausführungsformen die Kühlrohre 10 in Längsrichtung einpressen, um Module zu vereinen, wodurch sich eine besonders robuste und wärmeleitende Verbindung ergibt. Allerdings wird die Demontage etwas aufwändiger.

Fig. 17 zeigt wie mit diesen Modulen ein System-Paket gebildet werden kann. Als Vorteile ergeben sich für dieses Beispiel, dass der Wärmefluss bei ausschließlicher Luftkühlung nicht gestört wird und dass bei Flüssigkeitskühlung ein sehr zuverlässiger Wärmekontakt der Kühlrohre 10 mit den Kühlkörperprofilen 30 entsteht. Über die Unterseite des einteiligen Kühlkörpers 30 können über zweite Wärmeleitfolien 11 SMD-Bauelemente eines darunter liegenden Moduls gekühlt werden. Das oberste Modul weist zur Abdichtung ein wärmeleitendes Deckblech 31 auf.

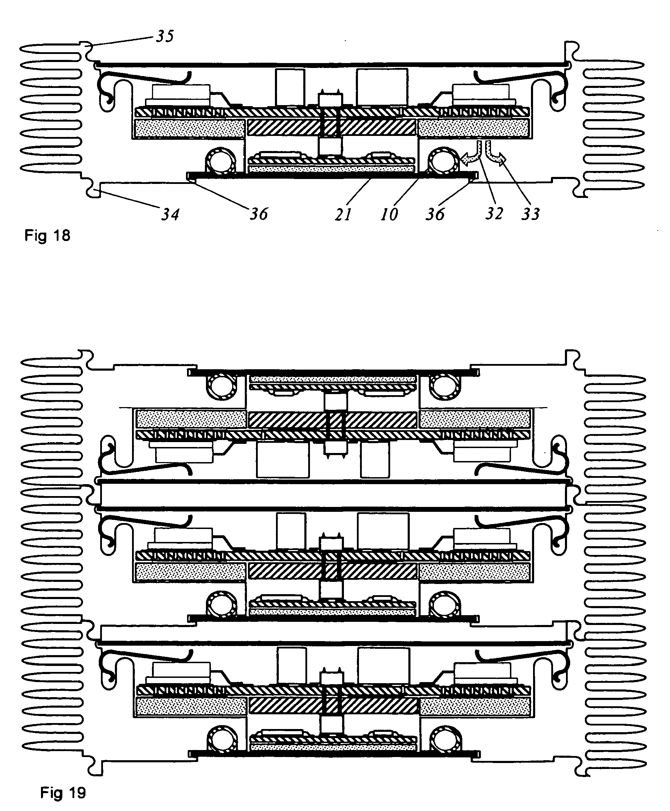

Die Ausführungsform der Fig. 18 zeigt, wie durch eine Verlagerung der Kühlrohre 10 gegen den Innenbereich des Moduls der Wärmefluss verbessert werden kann. Der Wärmefluss 32 gegen die Kühlrohre 10 ist hier vom Wärmefluss 33 gegen die Kühlrippen 22 größtenteils entkoppelt, womit alle Kühlkombinationen mit den gleichen Kühlprofilen realisiert werden können.

Als alternative Ausführungsform ist auch gezeigt, wie das verstärkte Bodenblech 21 über Aufnahmen 36 befestigt werden kann und wie auf die Kühlrohre 10 damit zusätzlicher, elastischer Druck ausgeübt werden kann.

Weiter sind in Fig. 18 eine negative Ausformung 34 und eine positive Ausformung 35 zur alternativen Stapelung der Module dargestellt, welche im Vergleich zu Fig. 12 invertiert sind. Dies gestattet es, die Module beliebig, insbesondere auch kopfüber zu stapeln.

Fig. 19 zeigt ein System-Paket nach diesem Prinzip. Das oberste Modul ist kopfüber angeordnet, womit ein Deckblech 31 eingespart werden kann. Die vorstehenden Ausformungen 34, 35 können zusätzlich zur stehenden oder hängenden Montage des System-Paketes dienen. Es genügt, nach dem seitlichem Einschieben einen einfachen Verriegelungsmechanismus zu aktivieren, um so sicheren Halt zu garantieren. Die Montage und Wartung der Module wird dadurch erheblich vereinfacht.

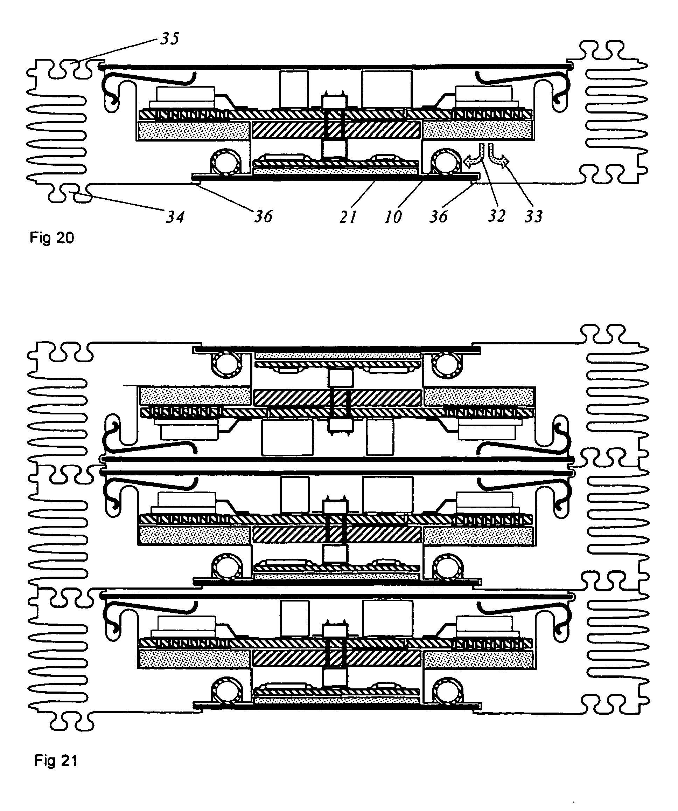

Fig. 20 zeigt eine Ausführungsform, die ähnlich zu der von Fig. 18 ist, mit dem Unterschied, dass durch die modifizierten Ausformungen 34, 35 der Wärmeübergang zu von einem Modul zu einem nächsten verbessert wird. Dies ist insbesondere in Fig. 21 zu sehen. Die Ausformungen 34, 35 sind so gestaltet, dass sie wie Puzzleteile ineinandergreifen und dadurch einen guten Wärmekontakt von einem Modul zum Nächsten ermöglichen. Dadurch ist auch eine verbesserte Kühlleistung gegeben, insbesondere bei ungleicher thermischer Belastung der Module und entsprechender Luftkühlung. Durch die Ausgestaltung der Ausformungen 34, 35 ist im Gegensatz zur Ausführungsform nach Fig. 18 und 19 ein seitliches Einschieben der einzelnen Module nicht mehr möglich.

System- Pakete nach dem Einrastverfahren können problemlos Transportschläge und Vibrationen ertragen, da die stirnseitigen Abdeckungen zusätzliche Festigkeit verleihen und dadurch ein Ausrasten zuverlässig verhindern.

Viele weitere Ausführungsformen und Kombinationen der vorliegenden Erfindung sind möglich. Der Fachmann kann bspw. beliebig Formen von Verzahnungen für die Stapelung, oder Höhen, Breiten und Längen der Module festlegen, sowie eine beliebige Anzahl von Kühlkörperprofilen 4 und Leiterplatten 2 pro Modul für seine speziellen Zwecke auswählen.

Die angeführten Beispiele dienen nur zum besseren Verständnis. Illustrative Angaben wie: oben, unten, negativ, positiv, seitlich, Bodenblech oder Deckblech sind nicht einschränkend zu verstehen.

## Patentansprüche

1. Hybrid-Kühlung für eine Leiterplatteneinheit für eine Werkzeugmaschine, mit: wenigstens einem Kühlkörper (4) der derart ausgebildet ist, dass er Wärme von oberflächenmontierbaren Leistungsbauelementen (1) auf der Leiterplatteneinheit aufnehmen kann, wobei der Kühlkörper einen Bereich zur Flüssigkeitskühlung und einen Bereich zur Luftkühlung aufweist, so dass er Wärme sowohl an ein gasförmiges als auch ein flüssiges Kühlmedium abgeben kann, **dadurch gekennzeichnet, dass** der Wärmefluss (32) zu den Bereichen des Kühlkörpers (4), die flüssig gekühlt werden, von dem Wärmefluss (33) zu den Bereichen des Kühlkörpers (4), die gasförmig gekühlt werden, entkoppelt ist.

2. Hybrid-Kühlung nach Anspruch 1, bei welcher der Bereich zur Flüssigkeitskühlung wenigstens einen Kanal (9) aufweist.

3. Hybrid-Kühlung nach Anspruch 1 oder 2, bei welcher der Bereich zur Luftkühlung ein Kühlkörperprofil (4) aufweist.

4. Hybrid-Kühlung nach einem der Ansprüche 1 bis 3, bei welcher das flüssige Kühlmedium das Kühl-Dielektrikum der Werkzeugmaschine umfasst.

5. Hybrid-Kühlung nach Anspruch 2, bei welcher Kühlrohre (10) in den Kanälen (9) angeordnet sind.

6. Hybrid-Kühlung nach Anspruch 5, bei welcher die Kühlrohre so dünnwandig sind, dass sie durch elastische Deformation den Kanälen (9) angepasst sind.

7. Hybrid-Kühlung nach Anspruch 3, bei welcher das Kühlkörperprofil so ausgestaltet ist, dass ein Kamineffekt bei dem das Kühlkörperprofil umgebenden gasförmigen Kühlmedium entsteht.

8. Hybrid-Kühlung nach einem der vorhergehenden Ansprüche, die ferner ein Gebläse zur Kühlluftzufuhr und/oder Kühlluftabfuhr aufweist.

9. Hybrid-Kühlung nach einem der vorhergehenden Ansprüche, bei welcher der Kühlkörper (4) positive und entsprechende negative Ausformungen (14, 15; 24, 25; 34, 35) aufweist, sodass mehrere Leiterplatteneinheiten, mit denen der Kühlkörper verbunden ist, so gestapelt werden können, dass die Ausformungen ineinander greifend verbunden werden können.

10. Hybrid-Kühlung nach Anspruch 3 oder 4, bei der der Kühlkörper so ausgebildet ist, dass er wenigstens einen elastischen Clip (23) so aufnehmen kann, dass die Kühlrohre (10) in die Kanäle (9) des Kühlkörpers (4) eingepresst werden.

11. Hybrid-Kühlung nach einem der vorhergehenden Ansprüche, bei welcher der Kühlkörper (4) eine Ausnehmung zur Aufnahme eines Teils eines Clips (5) aufweist, sodass der Clip auf das oberflächenmontierbares Leistungsbauelement (1) einen Anpressdruck ausübt, wenn der Kühlkörper (4) mit der Leiterplatteneinheit verbunden ist.

12. Hybrid-Kühlung nach Anspruch 11, bei der die Ausnehmung zur Aufnahme des Clips (5) eine Oberflächenstruktur aufweist, die geeignet ist die Reibung zwischen dem aufgenommenen Teil des Clip (5) und dem Aufnahmebereich zu erhöhen.

13. Verfahren zum Kühlen einer Leiterplatteneinheit für eine Werkzeugmaschine, bei welcher ein Kühlkörper (4), der Wärme von wenigstens einem oberflächenmontierbaren Leistungselement (1), das auf der Leiterplatteneinheit angeordnet ist, aufnimmt, sowohl durch ein flüssiges als auch ein gasförmiges Kühlmedium gekühlt wird, **dadurch gekennzeichnet, dass** der Wärmefluss (32) zu den Bereichen des Kühlkörpers (4), die flüssig gekühlt werden, von dem Wärmefluss (33) zu den Bereichen des Kühlkörpers (4), die gasförmig gekühlt werden, entkoppelt ist.

14. Verfahren nach Anspruch 13, bei welchem als flüssiges Kühlmittel das Dielektrikum einer Werkzeugmaschine verwendet wird.

## Claims

1. Hybrid cooling for a printed circuit board unit for a machine tool, comprising: at least one cooling body (4) which is configured such that it can absorb heat from surface mount power components (1) on the printed circuit board unit, the cooling body having a region for liquid cooling and a region for air cooling so that it can release heat both to a gaseous cooling medium and to a liquid cooling medium, **characterised in that** the thermal flux (32) to the regions of the cooling body (4) which are liquid-cooled is uncoupled from the thermal flux (33) to the regions of the cooling body (4) which are gas-cooled.

2. Hybrid cooling according to claim 1, wherein the region for liquid cooling has at least one channel (9).

3. Hybrid cooling according to claim 1 or claim 2, wherein the region for air cooling has a cooling body profile (4).

4. Hybrid cooling according to any one of claims 1 to 3, wherein the liquid cooling medium comprises the cooling dielectric medium of the machine tool.

5. Hybrid cooling according to claim 2, wherein cooling pipes (10) are arranged in the channels (9).

6. Hybrid cooling according to claim 5, wherein the cooling pipes have such thin walls that they are adapted to the channels (9) by elastic deformation.

7. Hybrid cooling according to claim 3, wherein the cooling body profile is configured such that a chimney effect develops for the gaseous cooling medium which surrounds the cooling body profile.

8. Hybrid cooling according to any one of the preceding claims, which further comprises a ventilator for the supply of cooling air and/or for the removal of cooling air.

9. Hybrid cooling according to any one of the preceding claims, wherein the cooling body (4) comprises positive and corresponding negative formations (14, 15; 24, 25; 34, 35), so that a plurality of printed circuit board units, to which the cooling body is connected, can be stacked such that the formations can be connected by engaging into one another.

10. Hybrid cooling according to claim 3 or claim 4, wherein the cooling body is configured such that it can receive at least one resilient clip (23), such that the cooling pipes (10) are pressed into the channels (9) of the cooling body (4).

11. Hybrid cooling according to any one of the preceding claims, wherein the cooling body (4) has a recess for receiving part of a clip (5), so that the clip exerts a contact pressure on the surface mount power component (1) when the cooling body (4) is connected to the printed circuit board unit.

12. Hybrid cooling according to claim 11, wherein the recess for receiving the clip (5) has a surface structure capable of increasing the friction between the received part of the clip (5) and the receiving region.

13. Method for cooling a printed circuit board unit for a machine tool, wherein a cooling body (4) which absorbs heat from at least one surface mount power element (1), arranged on the printed circuit board unit, is cooled both by a liquid cooling medium and by a gaseous cooling medium, **characterised in that** the heat flux (32) to the regions of the cooling body (4) which are liquid-cooled is uncoupled from the thermal flux (33) to the regions of the cooling body (4) which are gas-cooled.

14. Method according to claim 13, wherein the dielectric medium of a machine tool is used as the liquid cooling medium.

## Revendications

1. Refroidissement hybride pour une unité de carte de circuits imprimés pour une machine-outil avec :
au moins un corps de refroidissement (4) réalisé dé manière à pouvoir absorber de la chaleur d'éléments structurels de puissance (1) pouvant être montés sur la surface sur l'unité de carte de circuits imprimés, le corps de refroidissement présentant une zone pour le refroidissement par liquide et une zone pour le refroidissement à air de sorte à pouvoir transmettre de la chaleur non seulement à un fluide de refroidissement gazeux mais aussi liquide, **caractérisé en ce que** le flux thermique (32) vers les zones du corps de refroidissement (4) qui sont refroidies par liquide, est découplé du flux thermique (33) vers les zones du corps de refroidissement (4) qui sont refroidies au gaz.

2. Refroidissement hybride selon la revendication 1, pour lequel la zone pour le refroidissement par liquide présente au moins un canal (9).

3. Refroidissement hybride selon la revendication 1 ou 2, pour lequel la zone pour le refroidissement à air présente un profilé de corps de refroidissement (4).

4. Refroidissement hybride selon l'une quelconque des revendications 1 à 3, pour lequel le fluide de refroidissement liquide comporte le diélectrique de refroidissement de la machine-outil.

5. Refroidissement hybride selon la revendication 2, pour lequel des tubes de refroidissement (10) sont disposés dans les canaux (9).

6. Refroidissement hybride selon la revendication 5, pour lequel les tubes de refroidissement présentent une paroi mince de sorte à être adaptés par déformation élastique aux canaux (9).

7. Refroidissement hybride selon la revendication 3, pour lequel le profilé de corps de refroidissement est configuré de sorte qu'un effet de cheminée apparaisse lorsque le fluide de refroidissement gazeux entoure le profilé de corps de refroidissement.

8. Refroidissement hybride selon l'une quelconque des revendications précédentes, qui présente de plus une soufflante pour l'amenée et/ou l'évacuation d'air de refroidissement.

9. Refroidissement hybride selon l'une quelconque des revendications précédentes, pour lequel le corps de refroidissement (4) présente des déformations (14, 15 ; 24, 25; 34, 35) positives et négatives correspondantes de sorte que plusieurs unités de carte de circuits imprimés, auxquelles le corps de refroidissement est relié, peuvent être empilées de façon que les déformations puissent être reliées par engagement les unes dans les autres.

10. Refroidissement hybride selon la revendication 3 ou 4, pour lequel le corps de refroidissement est réalisé de sorte à pouvoir recevoir au moins un clip élastique (23) de façon que les tubes de refroidissement (10) soient enfoncés dans les canaux (9) du corps de refroidissement (4).

11. Refroidissement hybride selon l'une quelconque des revendications précédentes, pour lequel le corps de refroidissement (4) présente un évidement pour la réception d'une partie d'un clip (5) de sorte que le clip exerce une pression de serrage sur l'élément structurel de puissance (1) pouvant être monté sur la surface lorsque le corps de refroidissement (4) est relié à l'unité de carte de circuits imprimés.

12. Refroidissement hybride selon la revendication 11, pour lequel l'évidement présente, pour la réception du clip (5), une structure de surface qui convient à l'augmentation de la friction entre la partie reçue du clip (5) et la zone de réception.

13. Procédé de refroidissement d'une unité de carte de circuits imprimés pour une machine-outil, pour lequel un corps de refroidissement (4) qui absorbe de la chaleur d'au moins un élément de puissance (1) pouvant être monté sur la surface et est disposé sur l'unité de carte de circuits imprimés, est refroidi non seulement par un fluide de refroidissement liquide mais aussi par un fluide de refroidissement gazeux, **caractérisé en ce que** le flux thermique (32) vers les zones du corps de refroidissement (4) qui sont refroidies par liquide, est découplé du flux thermique (33) vers les zones du corps de refroidissement (4) qui sont refroidies par gaz.

14. Procédé selon la revendication 13, pour lequel le diélectrique d'une machine-outil est utilisé comme fluide de refroidissement liquide.
